# EUROPÄISCHE PATENTSCHRIFT

(11) **EP 2 442 375 B1**
(45) Veröffentlichungstag und Bekanntmachung des Hinweises auf die Patenterteilung: **21.06.2017**
(21) Anmeldenummer: 11185369.3
(22) Anmeldetag: 17.10.2011
(51) Int. Cl.: H01L 33/60, H01L 33/50, H01L 33/58

(54) **LED-ANORDNUNG MIT VERBESSERTER LICHTAUSBEUTE**
LED ASSEMBLY WITH IMPROVED LIGHT YIELD
AGENCEMENT DE DEL À EFFICACITÉ LUMINEUSE AMÉLIORÉE

(30) Priorität: 18.10.2010 DE 102010048561
(43) Veröffentlichungstag der Anmeldung: 18.04.2012
(73) Patentinhaber: ATMOS MedizinTechnik GmbH & Co. KG, 79853 Lenzkirch (DE)
(72) Erfinder: Czaniera, Jürgen, 79848 Bonndorf (DE)
(74) Vertreter: Westphal, Mussgnug & Partner Patentanwälte mbB

(56) Entgegenhaltungen:
- EP-A1- 1 452 797
- EP-A1- 2 113 951
- US-A1- 2004 032 728

## Beschreibung

Die Erfindung betrifft eine LED-Anordnung gemäß dem Oberbegriff des Anspruchs 1 und ein Verfahren zum Betrieb einer solchen LED-Anordnung.

In letzter Zeit spielen LEDs als Lichtquellen eine immer größere Rolle, da ihre Leistung im Hinblick auf Lichtfluss und Leuchtdichte kontinuierlich gesteigert werden konnte. Gleichzeitig geht mit dieser Entwicklung einher, dass die entsprechenden Power-LED-Chips immer größer werden. Bis ins Jahr 2000 wurde der Markt weitestgehend von quadratischen LED-Chips mit rund 0,3mm Kantenlänge beherrscht. Diese wurden zunächst von Chips mit ca. 1mm Kantenlänge abgelöst; seit ca. 2009 tauchen LEDs auf, deren Kantenlängen zwischen 3mm und 5mm liegen und die im Hinblick auf Lichtfluss und Leuchtdichte konkurrenzfähig mit Entladungslampen, z.B. Xenon-Hochdrucklampen, sind.

Bei LEDs handelt es sich um Lambertsche Strahler, bei denen jedes Oberflächenelement der LED sein Licht nach dem Lambertschen Cosinus-Gesetz in den gesamten Halbraum abstrahlt. Während diese Tatsache für großflächige Beleuchtung -beispielsweise bei für die Ausleuchtung eines Raumes- wünschenswert ist, wirkt sie sich immer dann negativ aus, wenn es darum geht, gezielt das von der Lichtquelle erzeugte Licht in ein der Lichtquelle auf dem Lichtweg nachgeordnetes optisches System einzukoppeln, dessen Fläche und Akzeptanzwinkel begrenzt sind, beispielsweise bei der Einkopplung in Lichtleiter, den Lichttunnel eines Beamers, Spot-Scheinwerfern und ähnlichen Systemen.

Dies liegt daran, dass durch die Lichtquelle ihr Etendue, also das Volumen, das die ausgesandte Strahlung im Phasenraum aufspannt, vorgegeben ist; gleichzeitig ist auf Grund des Liouville-Theorems unmittelbar klar, dass für den Etendue ein Entropiesatz gelten muss, also eine Verringerung des Volumens des ausgesandten Lichtbündels im Phasenraum nicht möglich ist. In paraxialer Näherung ist der Etendue sogar eine Lagrange-Invariante, also eine Erhaltungsgröße.

Mit einem optischen Beleuchtungssystem soll erreicht werden, dass das von einer Quelle ausgesandte Licht und damit sein Etendue so modifiziert werden soll, dass ein Objekt in einer gewünschten Art und Weise beleuchtet wird. Aus der Etendueerhaltung lässt sich dann folgern, wieviel Licht der Quelle nutzbar ist oder wie groß eine Quelle maximal sein darf, damit alles Licht genutzt werden kann.

Die sich hieraus im Zusammenhang mit modernen Hochleistungs-LEDs ergebenden Probleme lassen sich leicht am Beispiel der Einkopplung des Lichts in einen Lichtleiter mit einem typischen Durchmesser von ca. 3,5mm demonstrieren. Bei einer LED mit einer Fläche von 1mm x 1mm war es möglich, die strahlende Fläche über eine Optik zu vergrößern, die ein Bild des LED-Chips im Unendlichen bereitstellte und damit praktisch verlustlos eine derartige Verringerung des Abstrahlwinkels zu erreichen, dass eine vollständige Einkopplung in den Lichtleiter durch Anpassung der Winkelverteilung an die numerische Apertur des Lichtleiters ermöglicht wurde.

Im Gegensatz dazu ist bei einer Kantenlänge der LED von 3mm x 3mm die Diagonale des LED-Chips bereits 4,24mm, so dass die Ecken des LED-Chips nicht mehr auf den Lichtleiter abgebildet werden können. Aus der Etendueerhaltung folgt insbesondere, dass eine Verringerung der Fläche des abgestrahlten Lichts mit einer Verbreiterung der Winkelverteilung einhergehen muss, der ohnehin bereits bestehende Anteil des ausgestrahlten Lichts, der nicht die Akzeptanzbedingung des Lichtleiters erfüllt, würde also beim Versuch, eine bessere Ausnutzung der LED-Fläche zu erreichen größer, so dass die Ausbeute der Einkopplung nicht erhöht würde. Es entstehen erhebliche Verluste an nutzbarer Leistung.

Aus der US 2007018175 ist es bekannt, einen auf einem Substrat angeordneten LED-Chip mit einem Gehäuse in Form eines Gehäusedoms bekannt, der teilweise verspiegelt ist, um Lichtstrahlen, die von der LED unter Winkeln emittiert werden, die nicht in den Akzeptanzbereich eines nachgeordneten Lichtleiters fallen, auf die Oberfläche des LED-Chips zu reflektieren. Diese Vorgehensweise führt aber bestenfalls zu einer geringen Erhöhung der nutzbaren Lichtausbeute des LED-Chips.

Aus der EP 2 113 951 A1 und der US 2004/032728 A1 sind LED-Anordnungen mit einem Träger, einem auf dem Träger angeordneten LED-Chip und einem Reflektor, der einen Teil des bei Betrieb der LED-Anordnung von dem LED-Chip abgestrahlten Lichts reflektiert bekannt, bei denen die LED-Anordnung eine Lumineszenz-Konversionsschicht aufweist, auf die zumindest ein Teil des durch den Reflektor reflektierten Lichts gelenkt wird, wobei die Lumineszenz-Konversionsschicht auf dem LED-Chip angeordnet ist und der Reflektor so ausgestaltet ist, dass der Reflektor ein Bild des LED-Chips auf den LED-Chip abbildet.

Die EP 1 452 797 A1 offenbart eine Beleuchtungsvorrichtung mit einer Lichtquelle, Mittel zur Vorwärtsprojektion des von der Lichtquelle emittierten Lichts und einem reflektierenden Spiegel zur Vorwärtsreflexion des Lichts, bei der durch Variation des relativen Abstands von Lichtquelle, Vorwärtsprojektionsmittel und Reflexionsspiegel die geometrischen Eigenschaften des abgestrahlten Lichtkegels verändert werden können. Die Aufgabe der Erfindung besteht also darin, eine LED-Anordnung bereitzustellen, die eine verbesserte Lichtausbeute im Hinblick auf die Einkopplung des Lichtes in ein optisches System mit sich bringen.

Diese Aufgabe wird gelöst durch eine LED-Anordnung mit den Merkmalen des Anspruchs 1.

Die erfindungsgemäße LED-Anordnung weist zumindest einen Träger, einen auf dem Träger angeordneten LED-Chip und einen Reflektor, der einen Teil des bei Betrieb der LED-Anordnung von dem LED-Chip abgestrahlten Lichts reflektiert auf. Erfindungswesentlich ist, dass die LED-Anordnung ferner eine Lumineszenz-Konversionsschicht aufweist, auf die zumindest ein Teil des durch den Reflektor reflektierten Lichts gelenkt wird.

Die Erfindung basiert auf der Erkenntnis, dass eine signifikante Verbesserung der Lichtausbeute im Hinblick auf Licht, das in ein nachgeordnetes optisches System einkoppelbar ist, also dessen Akzeptanzbedingungen erfüllt, erzielbar ist, wenn das durch den LED-Chip bereitgestellte Licht, das die Akzeptanzbedingungen nicht erfüllt, als Energieversorgung für eine Sekundärlichtquelle verwendet wird. Dies geschieht insbesondere in einer Lumineszenz-Konversionsschicht, in der das auf sie reflektierte Primärlicht des LED-Chips absorbiert wird und dann ein Photon, das insbesondere eine andere, größere Wellenlänge besitzt, emittiert wird. Gleichzeitig wird damit der langwellige Bereich des Spektrums des Lichtes, das in das optische System eingespeist wird, verstärkt, was zu einer Absenkung der Farbtemperatur führt und das Licht wärmer erscheinen lässt.

Wesentlich für die bestimmungsgemäße Funktion der LED-Anordnung ist, dass die Lumineszenz-Konversionsschicht auf dem LED-Chip angeordnet ist und dass der Reflektor so ausgestaltet ist, dass der Reflektor ein Bild des LED-Chips auf den LED-Chip abbildet. Dies setzt voraus, dass die Ausdehnung des LED-Chips und der Reflektor aufeinander abgestimmt sein müssen. Insbesondere ist diese Bedingung nicht hinreichend gut für im wesentlichen sphärische oder parabolische Reflektoren erfüllt, wenn der Durchmesser bzw. die räumliche Ausdehnung des LED-Chips nicht um einen Faktor >3 kleiner, insbesondere >7 kleiner als der Durchmesser oder die räumliche Ausdehnung des Reflektors ist.

Es hat sich gezeigt, dass eine Ausgestaltung, bei der der Reflektor die Form eines Oberflächensegments einer Sphäre hat, LED-Chips, deren Ausdehnung (im Sinne des größten Abstands zwischen zwei Rändern des Chips) um einen Faktor 5 kleiner ist als der Durchmesser der Sphäre zu einer guten Abbildung des LED-Chips auf sich selbst führt, sehr gute Ergebnisse werden für einen Faktor 7 und exzellente Ergebnisse für einen Faktor 10 erzielt.

Durch die Anordnung der Lumineszenz-Konversionsschicht, also der Sekundärlichtquelle, auf dem LED-Chip wird gewährleistet, dass eine Einkopplung des durch die Sekundärlichtquelle erzeugten Lichts, das die Akzeptanzbedingung des optischen Systems erfüllt, in das optische System mit derselben Einkoppeloptik durchgeführt werden kann, die für den einkoppelbaren Anteil des vom LED-Chip emittierten Primärlichts verwendet wird.

Eine besonders einfache Ausgestaltung des Reflektors ist ein gekrümmter Spiegel. Dieser erlaubt darüber hinaus eine Sammlung oder Fokussierung von Primärlicht auf der Lumineszenz-Konversionsschicht bzw. Sekundärlichtquelle.

In einer weiteren vorteilhaften Variante ist der Reflektor so justierbar, dass die Abbildung des Bilds des LED-Chips auf den LED-Chip beeinflusst werden kann. Es hat sich gezeigt, dass eine derartige Justage wesentlich dafür ist, eine optimale Performance zu erzielen. Vielfältige Mittel zur Justage optischer Elemente sind dem Fachmann bekannt, weshalb hier auf ihre Aufzählung verzichtet wird.

In einer alternativen Ausgestaltung der Erfindung weist die LED-Anordnung eine Linse auf, mit der ein Bild der LED im Unendlichen bereitgestellt wird und der Reflektor ist ein Planspiegel, der vom LED-Chip aus gesehen hinter der Linse angeordnet ist und einen Teil des Lichtes auf den LED-Chip zurück abbildet. Diese Ausgestaltung ermöglicht es insbesondere in Anwendungsfällen, in denen ohnehin eine Anpassung der Apertur der Beleuchtung vorgesehen ist, die beispielsweise durch eine Blende erfolgt, durch Einsatz einer verspiegelten Blende die Lichtausbeute effektiv zu erhöhen. Die erfindungsgemäße Ausführungsform sieht vor, dass der Reflektor an der LED-Anordnung beweglich angeordnet ist, und zwar so, dass die Menge des auf die Lumineszenz-Konversionsschicht reflektierten Lichts variiert werden kann. Diese Ausführungsform bringt den besonderen Vorteil mit sich, dass die Farbtemperatur der LED-Anordnung einstellbar ist. Der Nutzer kann also den Farbeindruck, den das von der LED-Anordnung abgestrahlte Licht vermittelt, wählen. Dies ist beispielsweise bei medizinischen Anwendungen praktisch. Beispielsweise hat sich gezeigt, dass in der Endoskopie von Ärzten bei der Beurteilung entzündlicher Vorgänge ein warmer Farbton als natürlicher empfunden wird, während ein kälterer Farbton bei der Differenzierung von Blutgefäßen und Gewebestrukturen bevorzugt wird.

Einerseits ist dies von Bedeutung, weil die Fertigung von LEDs mit einer fest definierten Farbtemperatur großen Streuungen unterliegt, so dass man derzeit beim Kauf einer LED mit einer bestimmten Farbtemperatur lediglich eine LED erhält, deren Farbtemperatur irgendwo in einem relativ großen Bereich, dem sogenannten Bin, liegt. Beim Einsatz einer anderen LED, die zu demselben Bin gehört, kann ein merklich anderer Farbeindruck entstehen.

Andererseits ist zu berücksichtigen, dass die zuletzt genannte Ausführungsform eine Möglichkeit eröffnet, die Farbtemperatur ohne Effizienzverluste einzustellen. Herkömmlicherweise geht eine Änderung der Farbtemperatur stets mit einer geringeren Photonenausbeute einher. In der Ausgestaltung der Erfinder mit einem beweglichen Reflektor wird hingegen Licht, das nicht in das optische System einkoppelbar ist, weil es dessen Akzeptanzbedingungen nicht erfüllt und somit für die Anwendung nicht zur Verfügung steht dazu genutzt, die zusätzlichen, "wärmere" Farbkomponenten zur Verfügung zu stellen. Ein Verfahren zum Betrieb einer LED-Anordnung, weist zumindest die Schritte Erzeugen von Licht mittels eines LED-Chips, Reflektieren eines Teils des mittels des LED-Chips erzeugten Lichts und Einkoppeln von Licht in ein optisches System, das eine Akzeptanzbedingung aufweist, wobei nur Licht, das die Akzeptanzbedingung erfüllt in das optische System eingekoppelt wird, auf. Erfindungswesentlich ist dabei, dass das Licht auf eine Sekundärlichtquelle, die mit dem reflektierten Licht betreibbar ist, insbesondere eine Luminanzkonversionsschicht, reflektiert wird.

In einer besonders vorteilhaften Variante des Verfahrens ist ein Justageschritt vorgesehen, mit dem die Abbildung des Bilds des LED-Chips auf den LED-Chip optimiert werden kann. Dieser kann bei einem Testbetrieb vor der eigentlichen Verwendung des LED-Chips, insbesondere auch bei der Herstellung der LED-Anordnung, erfolgen, erfordert aber, dass dabei die LED Licht abgibt.

Die Erfindung wird im Folgenden anhand von Zeichnungen näher erläutert. Es zeigen:
- Fig.1:: Eine Skizze einer LED-Anordnung gemäß einem ersten Ausführungsbeispiel der Erfindung,
- Fig.2:: eine Skizze der LED-Anordnung aus Figur 1, wobei mit verschobenen Reflektoren, und
- Fig.3:: eine Skizze einer LED-Anordnung gemäß einem zweiten Ausführungsbeispiel der Erfindung.

In allen Figuren werden identische Bezugszeichen für gleiche Bauelemente gleicher Ausführungsbeispiele verwendet.

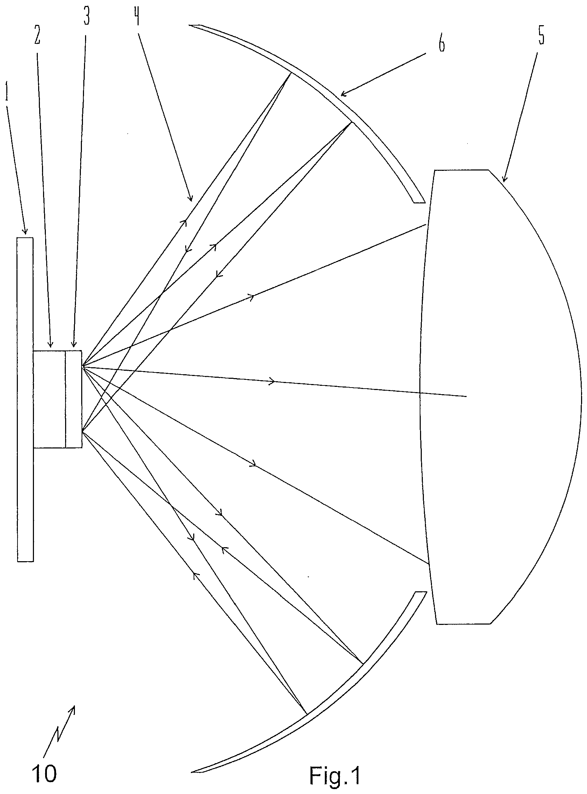

Figur 1 zeigt eine LED-Anordnung 10 gemäß einem ersten Ausführungsbeispiel der Erfindung. Man erkennt einen Träger 1, auf dem ein LED-Chip 2 angeordnet ist, der an seiner Oberfläche eine durch vom LED-Chip 2 emittierten Licht anregbare Sekundärlichtquelle in Form einer Lumineszenz-Konversionsschicht 3 aufweist, die aus Gründen der Übersichtlichkeit der Zeichnung übertrieben dick dargestellt ist. Beim Betrieb des LED-Chips 2 strahlt dieser Licht ab, das zum Teil durch die Lumineszenz-Konversionsschicht 3 hindurchtritt und zum Teil die Lumineszenz-Konversionsschicht 3 nach Absorption in dieser zur Abstrahlung von Licht mit einer größeren Wellenlänge anregt. Beide Arten von Licht breiten sich als Lichtstrahlen 4 im Raum aus. Ein Teil der Lichtstrahlen 4 trifft eine erste Linse 5, mit der sie zur Einkopplung in ein nicht dargestelltes nachfolgendes optisches System aufbereitet werden. Die Lichtstrahlen 4, die die Akzeptanzbedingung dieser Linse 5 nicht erfüllen, treffen auf in der Richtung zwischen Träger 1 und Linse 5 verschiebbar angeordnete Reflektoren 6 in Form von gewölbten Spiegeln, die diese Lichtstrahlen 4 auf die von der Lumineszenz-Konversionsschicht 3 gebildete Sekundärlichtquelle reflektieren. Dort werden diese Lichtstrahlen 4 zumindest teilweise absorbiert und regen die Lumineszenz-Konversionsschicht 3 zur Abstrahlung von Sekundärlicht, also weiteren Lichtstrahlen 4 an, die teilweise die Akzeptanzbedingung der Linse 5 erfüllen. Damit wird es möglich, bei veränderter spektraler Verteilung des Lichts ins-gesamt mehr Licht in das optische System einzubringen, also die LED-Anordnung 10 effizienter zu nutzen.

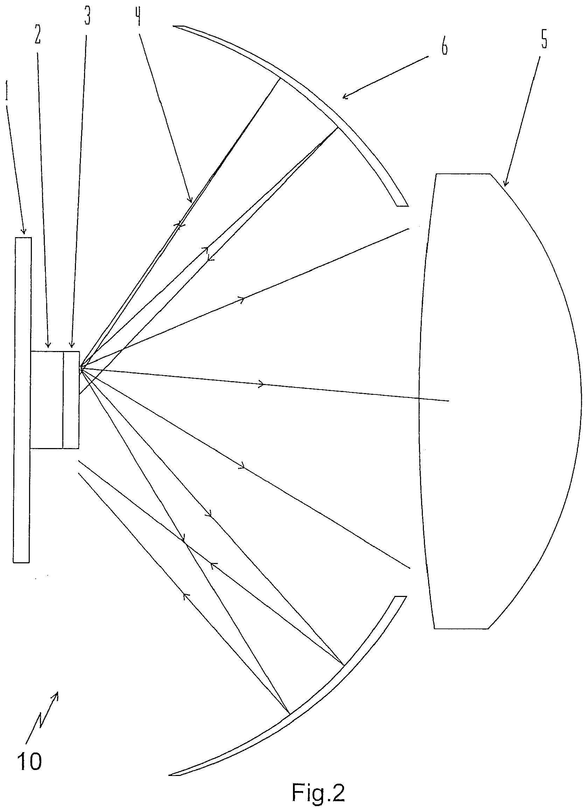

In Figur 2 ist dieselbe Ausführungsform der Erfindung gezeigt wie in Figur 1, der einzige Unterschied besteht darin, dass in Figur 2 die verschiebbar angeordneten Reflektoren 6 näher an dem LED-Chip angeordnet sind. Dies führt, wie in Figur 2 dargestellt, dazu, dass einige der reflektierten Lichtstrahlen 4 nicht mehr auf die Lumineszenz-Konversionsschicht 3 treffen, also eine weniger starke Effizienzsteigerung erreicht wird, die aber mit einer anderen spektralen Verteilung des in das optische System eingespeisten Lichts führt. Dies verdeutlicht, dass die Verschiebbarkeit der Reflektoren 6 zu einer einstellbaren spektralen Verteilung, entsprechend einer einstellbaren Farbtemperatur, führt.

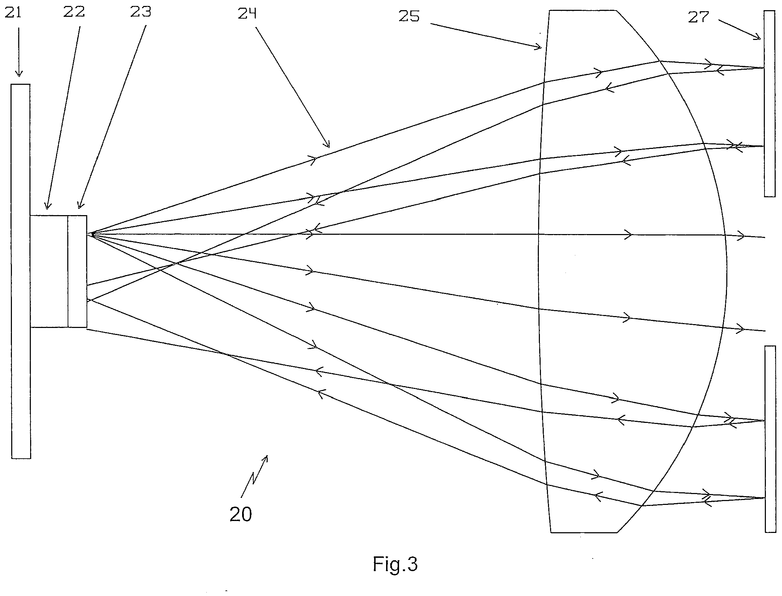

Figur 3 zeigt eine LED-Anordnung 20 gemäß einer zweiten Ausführungsform. Man erkennt wie in Figur 1 einen Träger 21, mit LED-Chip 22, der an seiner Oberfläche eine Lumineszenz-Konversionsschicht 23 aufweist. Beim Betrieb des LED-Chips 22 strahlt dieser Licht ab, das zum Teil durch die Lumineszenz-Konversionsschicht 23 hindurchtritt und zum Teil die Lumineszenz-Konversionsschicht 23 nach Absorption des Lichts zur Abstrahlung von Licht mit einer größeren Wellenlänge anregt. Beide Arten von Licht breiten sich als Lichtstrahlen 24 im Raum aus. Ein Teil der Lichtstrahlen 24 trifft eine erste Linse 25, mit der sie zur Einkopplung in ein nicht dargestelltes nachfolgendes optisches System aufbereitet werden.

Im Gegensatz zur Ausführungsform, die in den Figuren 1 und 2 gezeigt ist, wird hier eine Konzentration von nutzbaren Lichtstrahlen in der Nähe der nicht dargestellten optischen Achse dadurch erzielt, dass als Reflektor 27 eine planverspiegelte Blende verwendet wird. Die von dem Reflektor 27 reflektierten Lichtstrahlen 24 werden durch die erste Linse 25 auf die Lumineszenz-Konversionsschicht 23 abgebildet. Dort werden diese Lichtstrahlen 24 zumindest teilweise absorbiert und regen die Lumineszenz-Konversionsschicht 23 zur Abstrahlung von Sekundärlicht, also weiteren Lichtstrahlen 24 an, die teilweise die Akzeptanzbedingung der ersten Linse 25 erfüllen und zusätzlich auch in dem durchlässigen Bereich der planverspiegelten Blende auftreffen, also für das nachgelagerte optische System nutzbar sind. Damit wird es möglich, bei veränderter spektraler Verteilung des Lichts insgesamt mehr Licht achsennah in das optische System einzubringen, also erneut die LED-Anordnung effizienter zu nutzen.

Es wird darauf hingewiesen, dass in allen dargestellten Figuren klar zu erkennen ist, dass die LED-Chips 2,22 jeweils eine deutlich geringere räumliche Ausdehnung aufweisen als der Reflektor, was für die Erzielbarkeit einer Abbildung eines Bildes des LED-Chips 2,22 auf sich selbst durch den Reflektor eine wesentliche Voraussetzung ist.

### Bezugszeichenliste

- 1,21: Substrat
- 2,22: LED-Chip
- 3,23: Lumineszenz-Konversionsschicht
- 4,24: Lichtstrahlen
- 5,25: Linse
- 6,27: Reflektor
- 10,20: LED-Anordnung

## Patentansprüche

1. LED-Anordnung (10,20) mit einem Träger (1,21),
einem auf dem Träger (1,21) angeordneten LED-Chip (2,22) und mit einem Reflektor (6,27), der einen Teil des bei Betrieb der LED-Anordnung (10,20) von dem LED-Chip (2,22) abgestrahlten Lichts reflektiert, wobei
die LED-Anordnung (10,20) eine Lumineszenz-Konversionsschicht (3,23) aufweist, auf die zumindest ein Teil des durch den Reflektor (6,27) reflektierten Lichts gelenkt wird, wobei die Lumineszenz-Konversionsschicht (3,23) auf dem LED-Chip (2,22) angeordnet ist und wobei der Reflektor (6,27) so ausgestaltet ist, dass der Reflektor (6,27) ein Bild des LED-Chips (2,22) auf den LED-Chip (2,22) abbildet, **dadurch gekennzeichne t**, dass der Reflektor (56,27) an der LED-Anordnung (10,20) beweglich angeordnet ist, und zwar so dass die Menge des auf die Lumineszenz-Konversionsschicht (3,23) reflektierten Lichts variiert werden kann.

2. LED-Anordnung (10,20) nach Anspruch 1,
**dadurch gekennzeichnet, dass** der Reflektor (6,27) ein gekrümmter Spiegel ist.

3. LED-Anordnung (10,20) nach Anspruch 1 oder 2,
**dadurch gekennzeichnet, dass** der Reflektor so justierbar ist, dass die Abbildung des Bilds des LED-Chips auf den LED-Chip beeinflusst werden kann.

4. LED-Anordnung (10,20) nach Anspruch 1,
**dadurch gekennzeichnet, dass** die LED-Anordnung (10,20) eine Linse (5,25) aufweist, mit der ein Bild des LED-Chips (2,22) im Unendlichen bereitgestellt wird und dass der Reflektor (6,27) ein Planspiegel ist, der vom LED-Chip (2,22) aus gesehen hinter der Linse angeordnet ist und einen Teil des Lichtes auf den LED-Chip (2,22) zurück abbildet.

## Claims

1. LED arrangement (10, 20) having a carrier (1, 21), an LED chip (2, 22) arranged on the carrier (1, 21) and having a reflector (6, 27) that reflects a portion of the light emitted from the LED chip (2, 22) during operation of the LED arrangement (10, 20), wherein the LED arrangement (10, 20) has a luminescence conversion layer (3, 23) onto which at least one portion of the light reflected by the reflector (6, 27) is guided, wherein the luminescence conversion layer (3, 23) is arranged on the LED chip (2, 22), and wherein the reflector (6, 27) is formed in such a way that the reflector (6, 27) maps an image of the LED chip (2, 22) onto the LED chip (2, 22), **characterised in that** the reflector (56, 27) is arranged to be movable on the LED arrangement (10, 20), and indeed such that the amount of light reflected onto the luminescence conversion layer (3, 23) can be varied.

2. LED arrangement (10, 20) according to claim 1,
**characterised in that** the reflector (6, 27) is a curved mirror.

3. LED arrangement (10, 20) according to claim 1 or 2,
**characterised in that** the reflector is able to be adjusted in such that it can influence the mapping of the image of the LED chip onto the LED chip.

4. LED arrangement (10, 20) according to claim 1,
**characterised in that** the LED arrangement (10, 20) has a lens (5, 25) with which an image of the LED chip (2, 22) is provided extending to infinity and the reflector (6, 27) is a plane mirror that, when viewed from the LED chip (2, 22), is arranged behind the lens and maps back a portion of the light onto the LED chip (2, 22).

## Revendications

1. Dispositif à LED (10, 20) comprenant un support (1, 21), une puce à LED (2, 22) et un réflecteur (6, 27) qui réfléchit une partie de la lumière rayonnée par la puce à LED (2, 22) lors du fonctionnement du dispositif à LED (10, 20), ce dispositif à LED (10, 20) comprenant une couche de conversion luminescente (3, 23) sur laquelle au moins une partie de la lumière réfléchie par le réflecteur (6, 27) est déviée, la couche de conversion luminescente (3, 23) étant montée sur la puce à LED (2, 22) et le réflecteur (6, 27) étant conformé de manière à reproduire une image de la puce à LED (2, 22) sur cette puce à LED (2, 22),
**caractérisé en ce que**
le réflecteur (56, 27) est monté mobile sur le dispositif à LED (10, 20), et ce de sorte que la quantité de la lumière réfléchie sur la couche de conversion luminescente (3, 23) puisse varier.

2. Dispositif à LED (10, 20) conforme à la revendication 1,
**caractérisé en ce que**
le réflecteur (6, 27) est un miroir courbe.

3. Dispositif à LED (10, 20) conforme à la revendication 1 ou 2,
**caractérisé en ce que**
le réflecteur peut être ajusté de façon à pouvoir avoir une influence sur la reproduction de l'image de la puce à LED sur la puce à LED.

4. Dispositif à LED (10, 20) conforme à la revendication 1,
**caractérisé en ce qu'**
il comporte une lentille (5, 25) permettant d'obtenir une image de la puce à LED (2, 22) à l'infini et le réflecteur (6, 27) est un miroir plan qui est monté à l'arrière de la lentille à partir de la puce à LED (2, 22), et une partie de la lumière est reproduite en retour sur la puce à LED (2, 22).
